Europäisches Patentamt

European Patent Office

Office européen des brevets

(11) Veröffentlichungsnummer: **0 104 579**

**A1**

(12) # EUROPÄISCHE PATENTANMELDUNG

(21) Anmeldenummer: **83109271.3**

(22) Anmeldetag: **19.09.83**

(51) Int. Cl.³: **G 01 R 31/28**

(30) Priorität: **24.09.82 DE 3235501**

(43) Veröffentlichungstag der Anmeldung:
**04.04.84 Patentblatt 84/14**

(84) Benannte Vertragsstaaten:
**DE GB NL**

(71) Anmelder: **SIEMENS AKTIENGESELLSCHAFT**
**Berlin und München Wittelsbacherplatz 2**
**D-8000 München 2(DE)**

(72) Erfinder: **Kuck, Gerd, Dr. rer. nat.**
**Alfred-Schmidt-Strasse 37**
**D-8000 München 70(DE)**

(54) Vorrichtung zur Signaleinprägung in integrierte MOS-Schaltungen durch Elektronenbestrahlung mit Elektronen niedriger Energie.

(57) Eine Vorrichtung zur Signaleinprägung in eine elektronische Halbleiter-Schaltung durch Elektronenbestrahlung (PE) soll die zerstörungsfreie Signaleinprägung mit einem Elektronenstrahl bei MOS-Schaltungen in einer solchen Weise ermöglichen, daß dabei logik-kompatible Signale erzeugt werden können. Eine solche Vorrichtung weist mindestens eine Kapazität $(C, C_1, C_2)$ zur Aufladung durch die Elektronenbestrahlung (PE), mindestens einen elektronischen Halbleiter-Transistor $(T, T_1, T_2)$, der parallel zu der entsprechenden Kapazität $(C, C_1, C_2)$ geschaltet ist, und mindestens einen elektronischen Schalter (ES, FF, ST, N1, N2), von dem ein Eingang (E, S, R) mit der entsprechenden Kapazität $(C, C_1, C_2)$ elektrisch verbunden ist zur Aktivierung des elektronischen Schalters (ES, FF, ST, N1, N2) und von dem ein zweiter Kontakt (A, R, S) mit der Steuerelektrode des entsprechenden Transistors $(T, T_1, T_2)$ elektrisch verbunden ist zur Durchsteuerung dieses Transistors $(T, T_1, T_2)$ nach der entsprechenden Aktivierung des elektronischen Schalters (ES, FF, ST, N1, N2), auf.

FIG 1

EP 0 104 579 A1

Croydon Printing Company Ltd

SIEMENS AKTIENGESELLSCHAFT ·    Unser Zeichen
Berlin und München             VPA
                          82 P 1 8 4 1 E

Vorrichtung zur Signaleinprägung in integrierte MOS-Schaltungen durch Elektronenbestrahlung mit Elektronen niedriger Energie.

Die Erfindung betrifft eine Vorrichtung zur Signaleinprägung in eine integrierte MOS-Schaltung durch Elektronenbestrahlung nach dem Oberbegriff des Anspruchs 1.

Bei der Realisierung integrierter Digital-Schaltungen ist eine detaillierte Analyse eventuell auftretender Fehlfunktionen sehr wichtig. Zum Messen des Spannungs-Zeit-Verlaufs an internen Schaltungspunkten innerhalb einer integrierten Digital-Schaltung wird dabei mit Vorteil die Elektronenstrahl-Meßtechnik eingesetzt (H.P. Feuerbaum et al, IEEE J.-Solid-State Circuits 13, 1978, 319-325). Um die Fehleranalyse bei integrierten Digital-Schaltungen zu vereinfachen, ist es günstig, kleinere Funktionsblöcke einer integrierten Digital-Schaltung von der übrigen Schaltung elektrisch abzutrennen und in diese kleineren Funktionsblöcke geeignete Prüfsignale zu geben. Das Geben solcher Prüfsignale könnte durch den eingeprägten Strom eines Elektronenstrahls erfolgen.

Da die in der Elektronenstrahl-Meßtechnik üblichen Sondenströme kleiner als $10^{-6}$A sind, muß der eingeprägte Strom des Elektronenstrahls verstärkt werden, um in der integrierten Schaltung logik-kompatible Signale zu erzeugen. Von einer solchen stromverstärkenden Anordnung ist zu fordern, daß diese möglichst einfach realisiert werden kann und im Hinblick auf die Arbeitsfrequenzen

My 1 Bla / 13.9.1982

(Taktfrequenzen) der integrierten Digital-Schaltungen eine Bandbreite größer als 10 MHz hat.

Bei der Anwendung der Elektronenstrahl-Meßtechnik auf MOS-Schaltungen besteht nun das Problem darin, daß die Elektronenenergien auf Energien kleiner als 2,5 keV begrenzt werden, damit die abbildenden Elektronen nur wenig in die Transistor-Strukturen eindringen und keine bleibenden Schäden verursachen. Wegen der geringen Elektronenenergie und Eindringtiefe der Elektronen wird andererseits der Elektronenstrom, welcher beispielsweise in einen in Sperrichtung gepolten p-n-Halbleiterübergang eingeschossen wird, nur geringfügig verstärkt. Nach diesem zuletztgenannten Prinzip arbeiten bekannte Anordnungen bei Strahlspannungen größer als 10 kV. Wegen dieser für MOS-Schaltungen ungeeigneten Strahlspannungen scheidet ein solches Prinzip für den Einsatz an MOS-Schaltungen aus, weil sonst bleibende Schäden an den MOS-Schaltungen verursacht werden.

Der vorliegenden Erfindung liegt die Aufgabe zugrunde, eine Vorrichtung der eingangs genannten Art anzugeben, welche die zerstörungsfreie Signaleinprägung mit einem Elektronenstrahl bei MOS-Schaltungen in einer solchen Weise ermöglicht, daß dabei logik-kompatible Signale erzeugt werden können.

Diese Aufgabe wird erfindungsgemäß durch eine Vorrichtung nach dem Anspruch 1 gelöst. Ausgestaltungen und Vorteile der Erfindung sind in den Unteransprüchen, der Beschreibung und der Zeichnung dargestellt.

Ausführungsbeispiele der Erfindung werden im folgenden anhand der Zeichnung näher erläutert.

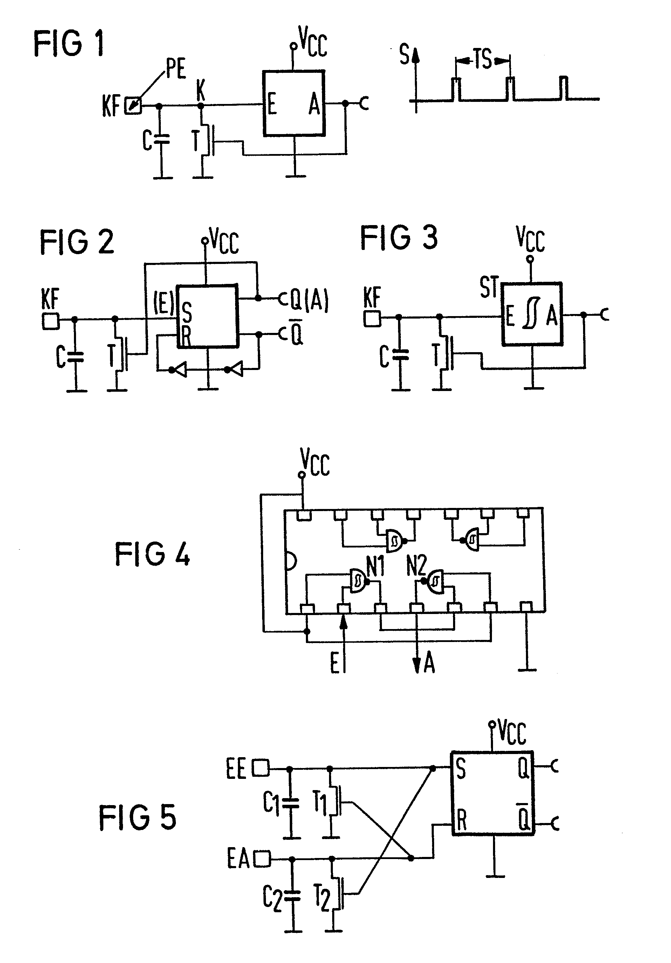

Fig.1 zeigen erfindungsgemäße Schaltungen, welche auf
mit 5 einem Chip mit einer digitalen MOS-Schaltung integriert und von einem Elektronenstrahl angesteuert
werden können.

Bei den in den Fig.1 mit 5 dargestellten erfindungsgemäßen Schaltungen sind die elektrischen Ausgangspegel
A, Q, $\overline{Q}$ kompatibel zu den Pegeln der eigentlichen MOS-
Logik-Schaltung.

Fig.1 mit 4 zeigen jeweils einen Elektronenstrahl-gesteuerten Oszillator.

Fig.5 zeigt einen Elektronenstrahl-gesteuerten Schalter.

Fig.1 zeigt eine Prinzipschaltung eines erfindungsgemäßen Elektronenstrahl-gesteuerten Oszillators. Die Oszillatorschaltung besteht aus einer Kapazität C, welche mit
einem Kontaktfleck (Pad) KF im Innern der Schaltung verbunden ist. Dieser Kontaktfleck KF nimmt den in die MOS-
Schaltung einzuprägenden Strom durch Elektronenbestrahlung PE auf. Dabei ist zu beachten, daß der eingeprägte
Strom bei Strahlspannungen PE kleiner als 2,5 kV positiv ist wegen der emittierten Sekundärelektronen. Daher
werden in den in der Zeichnung dargestellten Schaltungen
für die Transistoren T, $T_1$, $T_2$ n-MOS-Transistoren verwendet. Bei negativem eingeprägten Strom funktioniert
eine erfindungsgemäße Vorrichtung bei Verwendung von p-
MOS-Transistoren für die Transistoren T, $T_1$, $T_2$. Parallel zu dem Kondensator C ist ein MOS-Transistor T und
mitgekoppelter elektronischer Schalter ES angeschlossen.

Der elektronische Schalter ES hat einen Eingang E, einen Ausgang A und wird über eine Spannung $V_{CC}$ versorgt. Die Leckströme des selbstsperrenden MOS-Transistors T und der Eingangsstrom des Schalters ES müssen klein gegen den eingeprägten Elektronenstrom sein. Die erfindungsgemäße Anordnung funktioniert so, daß der Elektronenstrahl PE den Kondensator C auflädt, bis der elektronische Schalter ES den MOS-Transistor T durchsteuert. Die Kapazität C wird nun rasch entladen, bis der Schalter ES den Transistor T wieder sperrt, und der Vorgang beginnt von neuem. Das rechteckförmige Ausgangssignal S wird am Ausgang A des elektronischen Schalters ES aufgenommen. Der Ausgang A des elektronischen Schalters ES ist nicht-invertierend gegen den Eingang E des elektronischen Schalters ES.

Das Ausgangssignal S eines erfindungsgemäßen Oszillators nach Fig.1 weist eine Periodendauer TS von

$$TS = \Delta UC/i$$

auf mit $\Delta U$: Spannungshub am Kondensator C, C: Gesamtkapazität des Knotens K gegen Masse (inklusive Schaltkapazitäten), i: eingeprägter Elektronenstrom.

Fig.2 zeigt ein Ausführungsbeispiel eines Oszillators nach Fig.1. Der elektronische Schalter ES nach Fig.1 ist als ein RS-Flip-Flop-FF mit zwei Invertern zur Pulsverzögerung ausgeführt. Der Eingang S des RS-Flip-Flops FF ist als Eingang E und der Ausgang Q des Flip-Flops FF ist als Ausgang A benutzt. Der Ausgang $\overline{Q}$ ist über zwei in Reihe geschaltete Inverter an den Eingang R des Flip-Flops FF angeschlossen. Eine Vorrichtung nach Fig.2 eignet sich in besonderer Weise zur Integration in eine hochintegrierte MOS-Schaltung.

Fig.3 zeigt einen Oszillator nach Fig.1, bei dem der elektronische Schalter ES als Schmitt-Trigger ST mit sehr geringem Eingangsstrom ausgeführt ist.

Fig.4 zeigt einen käuflichen Baustein, welcher als elektronischer Schalter ES für eine Vorrichtung insbesondere nach Fig.3 verwendet werden kann. Dieser elektronische Baustein von Fig.4 mit der Bezeichnung CA 4093 B enthält vier NAND-Schmitt-Trigger. Von diesen vier NAND-Schmitt-Triggern werden die beiden NAND-Schmitt-Trigger N1, N2 hintereinandergeschaltet. Ein Eingang des NAND-Schmitt-Triggers wird als Eingang E des elektronischen Schalters ES verwendet, der Ausgang des anderen NAND-Schmitt-Triggers N2 wird als Ausgang A des elektronischen Schalters ES benutzt. Mit einem solchen elektronischen Schalter ES nach Fig.4 wurde ein Funktionsmodell für einen Oszillator nach Fig.1 gzw. nach Fig.3 aufgebaut und getestet. Als Transistor T wurde dabei ein n-MOS-Transistortyp IT 1750 von Intersil benutzt.

Fig.5 zeigt einen erfindungsgemäßen Elektronenstrahlgesteuerten Schalter. Dieser Schalter nach Fig.5 weist einen Schaltungsteil zum Einschalten dieses Schalters und einen Schaltungsteil zum Ausschalten dieses Schalters und einen RS-Flip-Flop FF entsprechend dem elektronischen Schalter ES nach Fig.1 auf. Der Schaltungsteil zum Einschalten dieses Schalters weist einen Kontaktfleck EE, eine Kapazität $C_1$ und einen Transistor $T_1$ auf. Der Schaltungsteil zum Ausschalten dieses Schalters weist einen Kontaktfleck EA, eine Kapazität $C_2$ und einen Transistor $T_2$ auf. Bei Elektronenbestrahlung des Kontaktflecks EE wird die Kapazität $C_1$ solange aufgeladen, bis über den aktivierten Eingang S des Flip-Flops FF der Ausgang Q dieses Flip-Flops FF aktiviert ist. Die Steuerelektrode des Transistors $T_2$, die mit dem Eingang S verbunden ist, ist dann ebenfalls aktiviert. Wenn also über den Kontaktfleck EE ein Signal in die Schaltung nach Fig.5 eingeprägt worden ist, ist sichergestellt, daß gleichzeitig die Kapazität $C_2$ des Ausschalte-Teilschaltkreises entladen ist. Wird nun der Kontaktfleck EA mit Elektronen bestrahlt, so wird die Kapazität $C_2$ solange aufgeladen, bis die Aktivierung des Eingangs R des Flip-Flops FF genügt, um den Ausgang $\bar{Q}$ des Flip-Flops FF zu aktivieren. Gleichzeitig wird in diesem Fall über einen Anschluß an den Eingang R der Transistor $T_1$ durchgesteuert. Damit ist sichergestellt, daß in diesem Fall die Kapazität $C_1$ entladen ist. Die Transistoren $T_1$, $T_2$ in Fig.5 verhindern, daß an den beiden Eingängen R, S des Flip-Flops FF gleichzeitig das Signal für eine logische 1 auftritt.

Um eine hohe Störsicherheit bei einem erfindungsgemäßen Schalter nach Fig.5 zu gewährleisten, werden die Eingangskapazitäten $C_1$, $C_2$ möglichst groß gewählt. Das Flip-Flop FF muß so aufgebaut sein, daß nach Anlegen der Versorgungsspannung $V_{CC}$ ein definierter Schaltzustand auftritt (in der Regel ist der Q-Ausgang dann "low"). Dies ist deshalb wichtig, weil eine auf einem Chip integrierte erfindungsgemäße Schaltung, sobald der Chip in ein Gehäuse eingeschlossen ist, von außen nicht mehr zugänglich ist. Mit einem Elektronenstrahl-gesteuerten Schalter nach Fig.5 können über Analog-Schalter (Transfer-Gates) einzelne Teilfunktionen oder zusätzliche Testsignal-Generatoren (z.B. Pseudo-Zufallsgeneratoren) einer integrierten Schaltung zu- oder abgeschaltet werden.

Die Erfindung ist nicht begrenzt auf Verwendung bei integrierten Schaltungen und ist auch nicht begrenzt auf Verwendung bei MOS-Schaltungen. Die Erfindung ist auch verwendbar für nicht-integrierte Schaltungen und ist verwendbar für beliebige elektronische Halbleiter-Schaltungen, bei denen eine Vorrichtung nach dem Anspruch 1 eine Logik-kompatible Signaleinprägung erlaubt.

Patentansprüche:

1. Vorrichtung zur Signaleinprägung in eine elektronische Halbleiter-Schaltung durch Elektronenbestrahlung (PE), g e k e n n z e i c h n e t durch mindestens eine Kapazität (C, $C_1$, $C_2$) zur Aufladung durch die Elektronenbestrahlung (PE), mindestens einen elektronischen Halbleiter-Transistor (T, $T_1$, $T_2$), der parallel zu der entsprechenden Kapazität (C, $C_1$, $C_2$) geschaltet ist, und mindestens einen elektronischen Schalter (ES, FF, ST, N1, N2), von dem ein Eingang (E, S, R) mit der entsprechenden Kapazität (C, $C_1$, $C_2$) elektrisch verbunden ist zur Aktivierung des elektronischen Schalters (ES, FF, ST, N1, N2) und von dem ein zweiter Kontakt (A, R, S) mit der Steuerelektrode des entsprechenden Transistors (T, $T_1$, $T_2$) elektrisch verbunden ist zur Durchsteuerung dieses Transistors (T, $T_1$, $T_2$) nach der entsprechenden Aktivierung des elektronischen Schalters (ES, FF, ST, N1, N2).

2. Vorrichtung nach Anspruch 1, g e k e n n z e i c h n e t durch eine Kapazität (C), einen elektronischen Halbleiter-Transistor (T) und einen elektronischen Schalter (ES, FF, ST, N1, N2) für einen Elektronenstrahl-gesteuerten Oszillator.

3. Vorrichtung nach Anspruch 1, g e k e n n z e i c h n e t durch zwei Kapazitäten ($C_1$, $C_2$), zwei elektronische Halbleiter-Transistoren ($T_1$, $T_2$) und einen elektronischen Schalter (FF) für einen Elektronenstrahl-gesteuerten Schalter.

FIG 1

FIG 2

FIG 3

FIG 4

FIG 5

**0104579**

Europäisches
Patentamt

## EUROPÄISCHER RECHERCHENBERICHT

Nummer der Anmeldung

| | EINSCHLÄGIGE DOKUMENTE | | | EP 83109271.3 |
|---|---|---|---|---|
| Kategorie | Kennzeichnung des Dokuments mit Angabe. soweit erforderlich. der maßgeblichen Teile | | Betrifft Anspruch | KLASSIFIKATION DER ANMELDUNG (Int Cl ³) |
| A | DE - A1 - 2 824 308 (SIEMENS) <br><br> * Seite 3, Zeile 20 - Seite 4, Zeile 5 * <br><br> -- | | 1 | G 01 R 31/28 |
| D,A | IEEE JOURNAL OF SOLID-STATE CIRCUITS, 13, 1978, No. 3 <br><br> H.P. FEUERBAUM et al. "Quantitative Measurement with High Time Resolution of Internal Waveforms on MOS RAM's Using a Modified Scanning Electron Microscope" Seiten 319-325 <br><br> ---- | | | |

RECHERCHIERTE
SACHGEBIETE (Int. Cl ³)

G 01 N 23/00

G 01 R 31/00

H 01 J 37/00

H 01 L 21/00

Der vorliegende Recherchenbericht wurde für alle Patentansprüche erstellt.

| Recherchenort | Abschlußdatum der Recherche | Prüfer |
|---|---|---|
| WIEN | 29-11-1983 | KUNZE |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82